# EUROPÄISCHE PATENTSCHRIFT

(11) **EP 0 766 094 B1**
(45) Veröffentlichungstag und Bekanntmachung des Hinweises auf die Patenterteilung: **29.05.2002**
(21) Anmeldenummer: 96114844.2
(22) Anmeldetag: 16.09.1996
(51) Int. Cl.: G01R 33/38

(54) **Magnetanordnung für ein diagnostisches Magnetresonanzgerät**
Magnet arrangement for a diagnostic magnetic resonance device
Arrangement d'aimants pour un appareil diagnostique de résonance magnétique

(30) Priorität: 28.09.1995 DE 19536261
(43) Veröffentlichungstag der Anmeldung: 02.04.1997
(73) Patentinhaber: SIEMENS AKTIENGESELLSCHAFT, 80333 München (DE)
(72) Erfinder: Frese, Georg, 91074 Herzogenaurach (DE); Siebold, Horst, Dr., 91090 Effeltrich (DE)

(56) Entgegenhaltungen:
- EP-A- 0 033 703
- EP-A- 0 609 604
- DE-A- 3 639 140
- DE-A- 4 412 755
- US-A- 5 365 927
- US-A- 5 448 214

## Beschreibung

Die Erfindung betrifft eine Magnetanordnung für ein diagnostisches Magnetresonanzgerät bestehend aus einer ersten und einer dazu benachbart in einem Abstand angeordneten zweiten magnetfelderzeugenden Einheit mit ersten bzw. zweiten äußeren Abmessungen quer zum Abstand, welche magnetfelderzeugenden Einheiten einen Bereich mit einem homogenen Magnetfeld festlegen, der überwiegend zwischen den beiden magnetfelderzeugenden Einheiten angeordnet ist, und mit einem quer zum Abstand der beiden magnetfelderzeugenden Einheiten ausgerichteten Zugang zu dem Bereich, wobei die zweiten äußeren Abmessungen kleiner als die ersten äußeren Abmessungen ausgebildet sind.

Eine Magnetanordnung der eingangs genannten Art ist aus der US-PS 5,084,677 bekannt. Die erste magnetfelderzeugende Einheit besteht aus mehreren konzentrisch ineinander angeordneten supraleitenden Spulen. Die Spulen sind so dimensioniert, daß sie innerhalb und außerhalb bei entsprechender Erregung ein homogenes Magnetfeld erzeugen. Zur weiteren Homogenisierung dieses Magnetfeldes und zur Minimierung der ersten magnetfelderzeugenden Einheit ist mit axialem Abstand zur ersten eine zweite magnetfelderzeugende Einheit angeordnet. Der durch den Abstand der beiden magnetfelderzeugenden Einheiten gegebene Zwischenraum ist als Zugang zum homogenen Feldbereich ausgebildet.

Eine andere Magnetanordnung ist aus der US-PS 5 365 927 bekannt. Bei der dort beschriebenen offenen Magnetanordnung sind als magnetfelderzeugende Einheiten zwei axial beabstandete supraleitende Spulen vorgesehen, zwischen denen ein Bereich mit einem weitgehend homogenen Magnetfeld vorhanden ist. Der homogene Magnetfeldbereich definiert das Abbildungsvolumen (FOV = field of view) des diagnostischen Magnetresonanzgeräts. Anzustreben ist ein möglichst großes Abbildungsnanzgeräts. Anzustreben ist ein möglichst großes Abbildungsvolumen. Der Patientenzugang erfolgt über eine zentrale Öffnung in den Magnetspulen entlang der magnetischen Achse der Magnetspulen. Für ärztliche Eingriffe an dem Patienten im Magnetresonanzgerät oder MRI-unterstützte Operationen (MRI = magnetic resonance imaging) ist ein Zugang quer zur Achse der Magnetspulen, also in transversaler Richtung, gegeben.

Aus der EP-OS 0 609 604 ist eine Magnetanordnung bekannt mit einer einzigen magnetfelderzeugenden Einheit. Die Magnetanordnung umfaßt zwei gegenüberliegend angeordnete Polschuhe, die über eine Flußrückführung miteinander verbunden sind. An einem der Polschuhe ist eine supraleitende Spule als magnetfelderzeugende Einheit angeordnet. Diesem Polschuh gegenüberliegend ist ein kleinerer passiver Polschuh ohne magnetischem Antrieb angeordnet. Der äußere Durchmesser des aktiven Polschuhs, also des Polschuhs, an dem die supraleitende Spule angeordnet ist, ist jedoch im Vergleich zum Polabstand groß. Daher ist bei dieser Magnetanordnung nur eine eingeschränkte Zugänglichkeit zum Abbildungsvolumen gegeben.

In der EP 0 033 703 A1 ist eine Magnetanordnung für ein Magnetresonanzgerät angegeben, das mindestens drei Spulenpaare umfaßt. Die drei Spulenpaare erlauben zum einen die Anzahl der Parameter zu erhöhen, des weiteren die Ungleichförmigkeit des Magnetfeldes zu reduzieren und außerdem ein Untersuchungsvolumen mit einem longitudinalen und einem transversalen Zugang bereitzustellen. Schließlich können so die Gesamtabmessungen ebenso wie die Verlustleistung minimiert werden. Die neuen Hauptparameter der Spulen werden so gewählt, daß die Gleichförmigkeit des Magnetfeldes im Untersuchungsvolumen optimiert ist. Dieses Magnetkonzept ist aufwendig. Zudem ist der transversale Zugang zum Untersuchungsvolumen durch die Spulen zum Teil behindert.

Der Erfindung liegt nun die Aufgabe zugrunde, eine Magnetanordnung für ein diagnostisches Magnetresonanzgerät mit einem großen homogenen Magnetfeldbereich und einer verbesserten Zugänglichkeit anzugeben.

Die Aufgabe wird dadurch gelöst, daß die erste magnetfelderzeugende Einheit eine Öffnung aufweist, die als weiterer Zugang zu dem Bereich ausgebildet ist. Zusätzlich zum wesentlich verbesserten seitlichen Zugangsbereich ist ein weiterer Zugang zum Abbildungsvolumen gegeben. Trotzdem ist das Abbildungsvolumen oder der Bereich mit homogener Feldverteilung ausreichend groß für diagnostische Anwendungen.

Sind die magnetfelderzeugenden Einheiten rotationssymmetrisch ausgebildet, kann der zweite Durchmesser kleiner als die Hälfte des ersten Durchmessers in Abhängigkeit der Zweckbestimmung des Magnetresonanzgeräts gemacht werden. Der mögliche Bereich des zweiten Durchmessers im Bezug zum ersten Durchmesser beträgt 1:2 bis 1:8.

Der Abstand der beiden magnetfelderzeugenden Einheiten zueinander liegt in einem Bereich vom halben ersten Durchmesser bis zum ganzen ersten Durchmesser.

Bei einer weiteren vorteilhaften Ausgestaltung umfaßt die magnetfelderzeugende Einheit - insbesondere auch bei dem kleineren Pol - einen Permanentmagneten.

Die Form des homogenen Magnetfeldbereichs kann in einer weiteren vorteilhaften Ausgestaltung durch eine Ausnehmung an einer dem Bereich zugewandten Seite des Polschuhs den Anforderungen angepaßt werden.

Eine Vergrößerung des homogenen Bereichs bei einer gleichzeitigen Verringerung des Streufeldes ergibt sich gemäß einer weiteren vorteilhaften Ausgestaltung, wenn die magnetfelderzeugenden Einheiten an dem Bereich abgewandten Seiten von einem ferromagnetischen Material umgeben sind.

Eine weitere, wesentliche Vergrößerung des homogenen Magnetfeldbereichs bei gleichzeitiger Verringerung des Streufeldes ergibt sich bei einer weiteren vorteilhaften Ausgestaltung dadurch, daß die beiden magnetfelderzeugenden Einheiten mit einer Flußrückführung aus einem ferromagnetischen Material miteinander verbunden sind.

Die Erfindung wird im folgenden anhand von 9 Figuren erläutert. Es zeigen:
- FIG 1: eine offene Magnetanordnung mit einer guten Zugänglichkeit zum homogenen Feldbereich,
- FIG 2: eine Magnetanordnung mit einem gegenüber der Anordnung nach FIG 1 vergrößerten homogenen Feldbereich,
- FIG 3: eine Magnetanordnung mit einem Permanentmagneten,
- FIG 4: eine Magnetanordnung mit einem Permanentmagneten, des sen Oberfläche strukturiert ist, zur Vergrößerung des homogenen Bereichs,
- FIG 5: eine Magnetanordnung mit einem Elektromagneten und einem Permanentmagneten, die über eine magnetische Rückführung miteinander verbunden sind,
- FIG 6: eine Magnetanordnung mit zwei Permanentmagneten, die über eine magnetische Rückführung miteinander verbunden sind,
- FIG 7: eine perspektivische Ansicht einer erfindungsgemäßen Magnetanordnung zur Untersuchung von Teilbereichen des menschlichen Körpers, hier in der Anwendung zur Kopfuntersuchung,
- FIG 8: dieselbe Anordnung wie nach FIG 7 in einer Anwendung für Orthopädie und
- FIG 9: eine für Ganzkörperuntersuchungen und für interventionelle Eingriffe angepaßte Magnetfeldanordnung mit einem elliptischen homogenen Magnetfeldbereich.

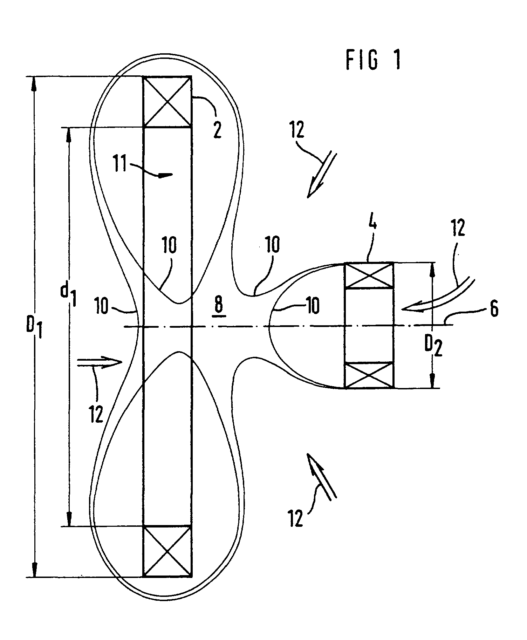

FIG 1 zeigt in einer Schnittdarstellung eine Seitenansicht einer Magnetanordnung für ein diagnostisches Magnetresonanzgerät mit einer ersten, als Magnetspule ausgebildeten magnetfelderzeugenden Einheit 2 und einer dazu axial beabstandeten zweiten, ebenfalls als Magnetspule ausgebildeten magnetfelderzeugenden Einheit 4. Tragkörper für die magnetfelderzeugenden Einheiten 2 und 4 sind hier nicht dargestellt, sie lassen sich mit bekannten konstruktiven Mitteln realisieren. Ebenso sind hier nicht die zum Magnetresonanzgerät gehörenden Gradientenspulen, Hochfrequenzantennen, Hochfrequenzabschirmungen, Patientenliege, Steuerrechner usw. dargestellt. Die beiden magnetfelderzeugenden Einheiten 2 und 4 sind rotationssymmetrisch zu einer Symmetrieachse 6 ausgebildet und besitzen einen erstem bzw. zweiten äußeren Durchmesser D₁ bzw. D₂. Beispielsweise ist der erste äußere Durchmesser D₁ = 1m und der zweite äußere Durchmesser D₂ = 0,3m groß. Zwischen den beiden magnetfelderzeugenden Einheiten 2 und 4, hier zusätzlich noch im Innenraum der magnetfelderzeugenden Einheit 2, liegt ein Bereich 8, worin ein weitgehend homogenes Magnetfeld erzeugt werden kann, wenn die beiden Elektromagnetspulen 2 und 4 von einem entsprechenden Gleichstrom erregt werden. Zur Veranschaulichung der Ausdehnung des homogenen Bereichs 8 sind Isokonturlinien 10 des Betrags der magnetischen Feldstärke eingezeichnet, die den homogenen Feldbereich 8 begrenzen.

Die Magnetspule 2 umschließt eine Öffnung 11, deren Innendurchmesser D₁ so groß gewählt ist, daß - auch wenn sie Bestandteil eines Magnetresonanzgeräts ist - einem Patienten, dessen Längsachse parallel zur Symmetrieachse 6 liegt, ein bequemer Zugang zum homogenen Feldbereich 8 möglich ist. Der Innendurchmesser D₁ liegt z.B. in der Größenordnung von 60 cm bis 100 cm. Mit der Größe der ersten magnetfelderzeugenden Einheit wächst zwar der homogene Bereich 8, aber auch die zur Erregung der Elektromagnetspule benötigte Leistung. Auch über die Größe der zweiten magnetfelderzeugenden Einheit 4 läßt sich Form und Größe des homogenen Feldbereichs 8 beeinflußen. Zusätzlich läßt sich über das Verhältnis der äußeren Durchmesser D₁ und D₂ der beiden Magnetspulen 2 und 4 zueinander die Lage und Form des homogenen Feldbereichs 8 optimieren. Das Verhältnis D₁/D₂ kann in einem Bereich von 2 bis 8, vorzugsweise von 3 bis 6 liegen.

Pfeile 12 verdeutlichen die Zugangsmöglichkeiten zum homogenen Feldbereich 8 dieser offenen Magnetanordnung. Die Zugangsmöglichkeiten 12 werden gegebenenfalls eingeschränkt durch die benötigten und hier nicht dargestellten Haltevorrichtungen für die magnetfelderzeugenden Einheiten 2 und 4, wobei jedoch in der konstruktiven Ausgestaltung eine weitgehende Freiheit besteht. Die Zugangsmöglichkeiten 12 können sowohl als Zugang des Patienten zum homogenen Feldbereich 8, wie auch als Eingriffsmöglichkeit eines Arztes für interventionelle, MRI-geführte Techniken ausgebildet sein.

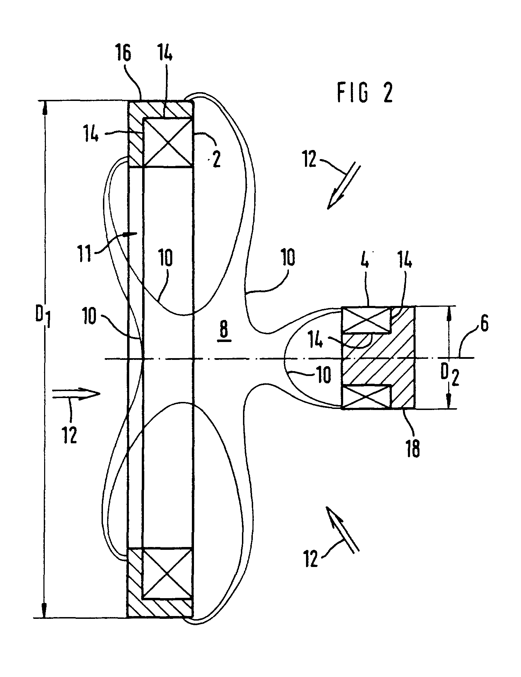

FIG 2 zeigt eine Magnetanordnung, die gegenüber der Magnetanordnung nach FIG 1 einen vergrößerten Bereich 8 besitzt. Zusätzlich ist das Streufeld außerhalb der Magnetanordnung verringert. Das wird dadurch erreicht, daß die Magnetspulen 2 und 4 an dem Bereich 8 abgewandten Seiten 14 von einem ferromagnetischen Material, z.B. Eisen, umgeben sind. Die erste Magnetspule 2 ist von einem im Querschnitt L-förmigen Ring 16 an den Seiten 14 abgedeckt. Bei der zweiten Magnetspule 4 besitzt der ferromagnetische Körper 18 einen T-förmigen Querschnitt, wobei ein flanschförmiger Teil des Körpers 18 die dem homogenen Feldbereich 8 abgewandte Seite 14 abdeckt. Der ferromagnetische Körper 18 bewirkt zudem, daß das Verhältnis der beiden Außendurchmesser D₁/D₂ im Vergleich zur Ausführung nach FIG 1 größer gemacht werden kann, ohne den homogenen Magnetfeldbereich 8 zu verschlechtern.

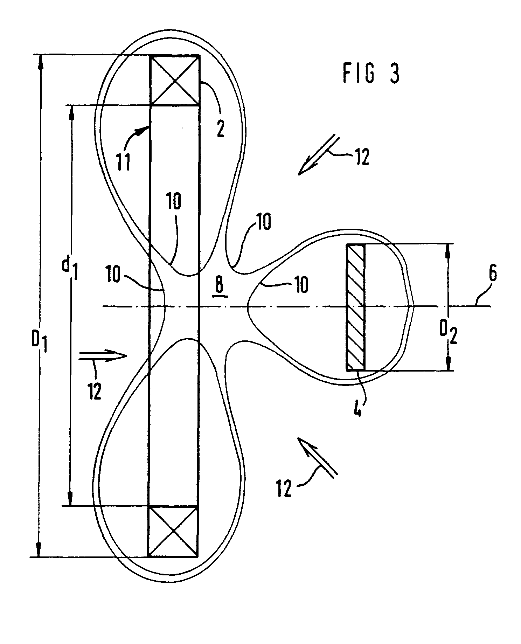

FIG 3 zeigt eine weitere Variante der Anordnung nach FIG 1, bei der die zweite magnetfelderzeugende Einheit 4 aus einem plattenförmigen, kreisrunden Permanentmagneten besteht. Als Permanentmagnetmaterial eignen sich Seltene-Erden-Legierungen. Die Magnetisierung der Permanentmagnetplatte 4 ist parallel zur Symmetrieachse 6 ausgerichtet.

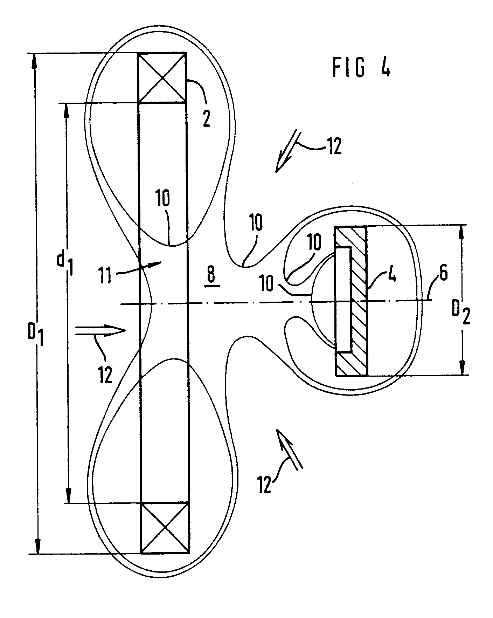

Auch bei der in FIG 4 dargestellten Magnetanordnung besteht die zweite magnetfelderzeugende Einheit 4 aus einem Permanentmagneten. Die dem homogenen Magnetfeldbereich 8 zugewandte Seite des Permanentmagneten 4 ist hier strukturiert, um den Bereich 8 homogener Feldstärke zu vergrößern oder um dem Bereich 8 eine gewünschte Form zu geben. Hier ist der Querschnitt des rotationssymmetrischen Permanentmagneten 4 u-förmig ausgebildet.

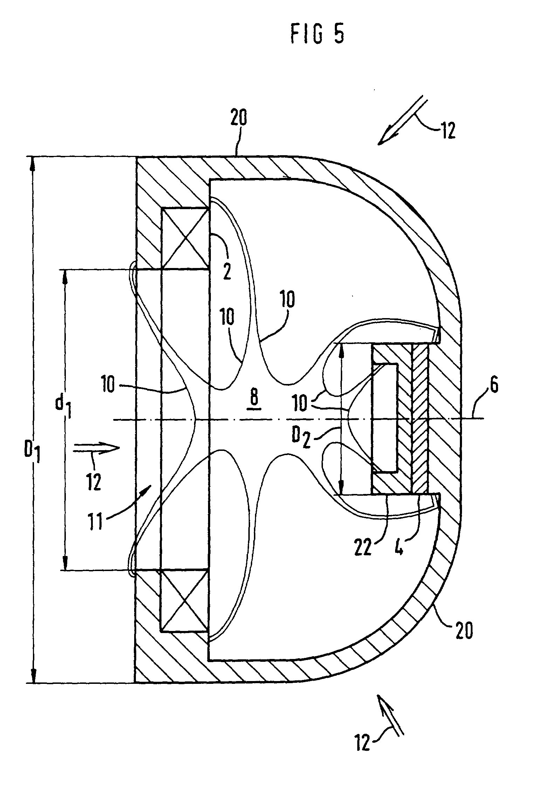

Bei der in FIG 5 gezeigten Ausführungsform sind die beiden magnetfelderzeugenden Einheiten 2 und 4 über eine Flußrückführung 20 miteinander verbunden. Die Flußrückführung 20 verringert gegenüber einer Magnetanordnung ohne Rückführung das Streufeld, verringert die Leistungsaufnahme bzw. den Einsatz von Permanentmagnetmaterial und vergrößert den homogenen Feldbereich 8. Hier besteht die Rückführung 20 aus zwei bogenförmigen Jochteilen, die gegenüberliegend angeordnet die beiden magnetfelderzeugenden Einheiten 2 und 4 miteinander verbinden. Die zweite magnetfelderzeugende Einheit ist hier als Permanentmagnetplatte 4 ausgebildet. An der dem Bereich 8 zugewandten Seite der Platte 4 ist ein Polschuh 22 angeordnet, der im Querschnitt u-förmig ausgebildet ist. Die Kombination von Permanentmagnetplatte 4 mit dem Polschuh 22 erzielt denselben Effekt, wie der strukturierte Permanentmagnet 4 der in FIG 4 dargestellten Ausführungsform.

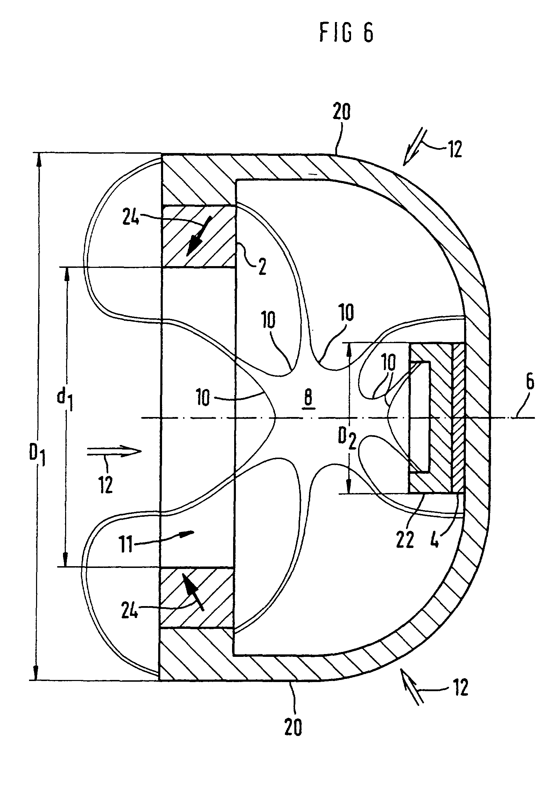

Bei der Magnetanordnung nach FIG 6 ist im Unterschied zur Anordnung nach FIG 5 die erste magnetfelderzeugende Einheit 2 durch einen Permanentmagnetring realisiert. Die Magnetisierung, symbolisiert durch Pfeile 24, besitzt eine radiale Komponente und eine Komponente parallel zur Symmetrieachse 6. Bei der hier gewählten Ausrichtung von ca. 30° nach außen ergibt sich ein nahezu kugelförmiger Bereich 8 mit homogener Feldverteilung.

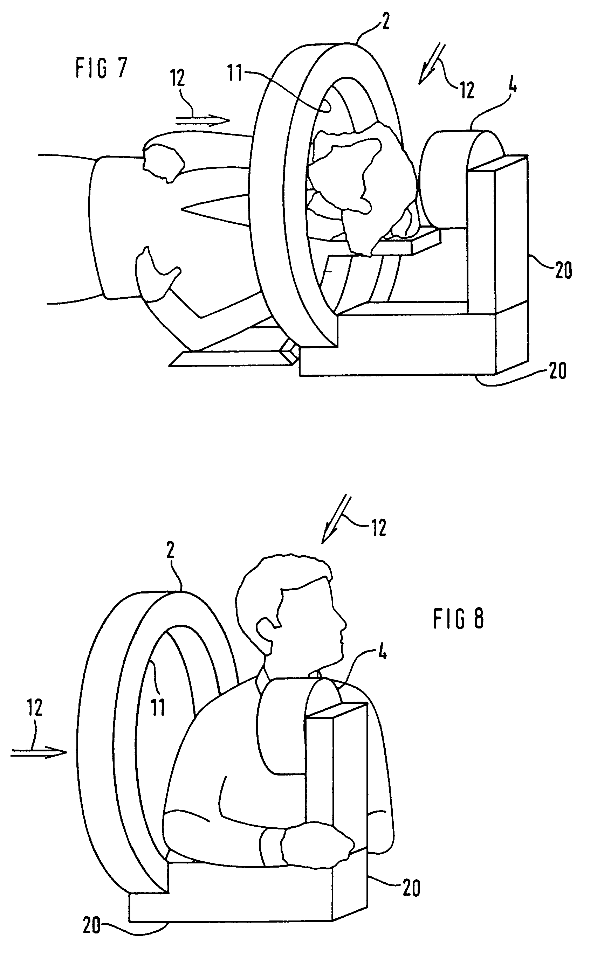

FIG 7 und 8 zeigen nun in einer perspektivischen Ansicht die Magnetanordnung für ein insbesondere für Untersuchungen von Teilbereichen des menschlichen Körpers geeignetes Magnetresonanzgerät. Der Abstand der beiden magnetfelderzeugenden Einheiten 2,4 liegt hier in der Größenordnung des halben äußeren Durchmessrs D₁ der ersten magnetfelderzeugenden Einheit,sodaß sich ein im wesentlichen kugelförmiger homogener Feldbereich 8 ergibt. Die offene Magnetanordnung bietet eine gute Zugänglichkeit zum homogenen Feldbereich 8 und damit auch vielfältige Anwendungsmöglichkeiten. FIG 7 zeigt die Anwendung für Kopfuntersuchungen, wobei die Möglichkeit für interventionelle Eingriffe von der Seite gegeben ist. FIG 8 zeigt dagegen eine Anwendung in der Orthopädie, wobei Eingriffsmöglichkeiten in axialer Richtung der Anordnung möglich sind.

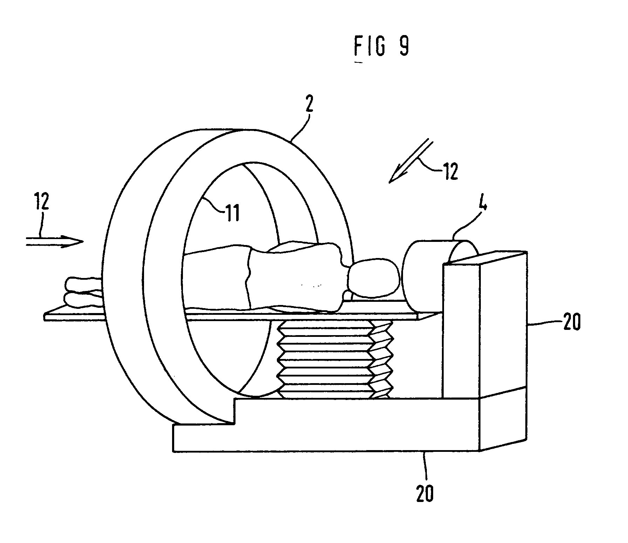

Die in FIG 9 in perspektivischer Ansicht gezeigte Magnetanordnung besitzt einen länglichen Bereich 8 durch den vergrößerten Abstand der beiden magnetfelderzeugenden Einheiten 2,4. Der Abstand liegt im Bereich des äußeren Durchmessers D₁ der ersten magnetfelderzeugenden Einheit 2. Diese Form des Bereichs 8 ist besonders vorteilhaft bei Ganzkörperuntersuchungen, wobei durch den vergrößerten Abstand der beiden magnetfeiderzeugenden Einheiten 2,4 zusätzlich noch eine verbesserte Zugänglichkeit zum Bereich 8 gegeben ist.

Gemeinsam ist den in FIG 7, 8 und FIG 9 dargestellten Magnetanordnungen eine c-förmige magnetische Flußrückführung 20.

Das Abbildungsvolumen kann auch auf weniger homogene Bereiche ausgedehnt und damit beträchtlich vergrößert werden, wenn das Magnetresonanzgerät mit einem Korrektur-Algorithmus arbeitet, der von inhomogenen Feldern verursachte Bildartefakte korrigiert. Beispielhaft wird auf die in den Proceedings of the Society of Magnetic Resonance and the European Society for Magnetic Resonance In Medicine and Biology, Nice, France, August 19-25, 1995, Volume 1, erschienen die Artikel von Krieg, Werthner, Ladebeck: "COSESS & INSESS - Coherent & Incoherent Spin - Echo in the Steady State" p. 695 oder von Luk Pat, Kerr, Nishimura: "Inhomogeneity Correction for Echo-Planar Imaging with a Polynomial Estimate of the Field Map", p. 617 oder von Jezzard, Balaban: Correction for Geometric Distortion in Echo Planar Images from B_{O} Inhomogeneities" p. 104 verwiesen.

## Patentansprüche

1. Magnetanordnung für ein diagnostisches Magnetresonanzgerät bestehend aus einer ersten und einer dazu benachbart in einem Abstand angeordneten zweiten magnetfelderzeugenden Einheit (2 bzw. 4) mit ersten bzw. zweiten äußeren Abmessungen quer zum Abstand (D₁ bzw. D₂), welche magnetfelderzeugenden Einheiten (2,4) einen Bereich (8) mit einem homogenen Magnetfeld festlegen, der überwiegend zwischen den beiden magnetfelderzeugenden Einheiten (2,4) angeordnet ist, und mit einem quer zum Abstand der beiden magnetfelderzeugenden Einheiten (2,4) ausgerichteten Zugang (12) zu dem Bereich (8),wobei die zweiten äußeren Abmessungen (D₂) kleiner als die ersten äußeren Abmessungen (D₁) ausgebildet sind, **dadurch gekennzeichnet, daß** die erste magnetfelderzeugende Einheit (2) eine Öffnung (11) aufweist, die als weiterer Zugang zu dem Bereich (8) ausgebildet ist.

2. Magnetanordnung nach Anspruch 1, **dadurch gekennzeichnet, daß** die magnetfelderzeugenden Einheiten (2,4) quer zum Abstand rotationssymmetrisch ausgebildet sind, wobei die ersten und zweiten äußeren Abmessungen quer zum Abstand (D₁, D₂) durch einen ersten bzw. zweiten Durchmesser festgelegt sind.

3. Magnetanordnung nach Anspruch 2, **dadurch gekennzeichnet, daß** der zweite äußere Durchmesser (D₂) kleiner als die Hälfte des ersten äußeren Durchmessers (D₁) ist.

4. Magnetanordnung nach Anspruch 2 oder 3, **dadurch gekennzeichnet, daß** der zweite äußere Durchmeser (D₂) sich zum ersten äußeren Durchmesser (D₁) verhält wie 1:2 bis 1:8.

5. Magnetanordnung nach einem der Ansprüche 1 bis 4, **dadurch gekennzeichnet, daß** ein Abstand der beiden magnetfelderzeugenden Einheiten (2,4) zueinander im Bereich eines halben bis ganzen ersten äußeren Durchmessers (D₁) liegt.

6. Magnetanordnung nach einem der Ansprüche 1 bis 6, **dadurch gekennzeichnet, daß** die erste magnetfelderzeugende Einheit (2) als Ring ausgebildet ist.

7. Magnetanordnung nach einem der Ansprüche 1 bis 7, **dadurch gekennzeichnet, daß** mindestens eine magnetfelderzeugende Einheit (2) einen Permanentmagneten umfaßt.

8. Magnetanordnung nach einem der Ansprüche 1 bis 8, **dadurch gekennzeichnet, daß** die erste magnetfelderzeugende Einheit (2) einen ringförmigen Permanentmagneten umfaßt, der eine Magnetisierung (24) mit einer radial ausgerichteten Komponente besitzt.

9. Magnetanordnung nach einem der Ansprüche 1 bis 9, **dadurch gekennzeichnet, daß** mindestens eine magnetfelderzeugende Einheit (2,4) einen resistiven Elektromagneten umfaßt.

10. Magnetanordnung nach einem der Ansprüche 1 bis 9, **dadurch gekennzeichnet, daß** die zweite magnetfelderzeugende Einheit (4) an einer dem Bereich des homogenen Magnetfeldes (8) zugewandten Seite eine Ausnehmung aufweist.

11. Magnetanordnung nach einem der Ansprüche 1 bis 10, **dadurch gekennzeichnet, daß** die magnetfelderzeugenden Einheiten (2,4) an dem Bereich des homogenen Magnetfeldes (8) abgewandten Seiten (14) von einem ferromagnetischen Material (16, 18) umgeben sind.

12. Magnetanordnung nach einem der Ansprüche 1 bis 12, **dadurch gekennzeichnet, daß** die beiden magnetfelderzeugenden Einheiten (2,4) mit einer Flußrückführung (20) aus einem ferromagnetischen Material miteinander verbunden sind.

## Claims

1. Magnet arrangement for a diagnostic magnetic resonance apparatus, comprising a first and a second magnetic field-producing unit (2 and 4, respectively), the second one being arranged next to the first at a distance, which magnetic field-producing units (2, 4) respectively have first and second external dimensions transverse to the distance (D₁ and D₂, respectively) and define a region (8) with a homogeneous magnetic field which is arranged predominantly between the two magnetic field-producing units (2, 4), and with an access (12) to the region (8) that is aligned transverse to the distance between the two magnetic field-producing units (2, 4), the second external dimensions (D₂) being smaller than the first external dimensions (D₁), **characterized in that** the first magnetic field-producing unit (2) has an opening (11) which is designed as further access to the region (8).

2. Magnet arrangement according to Claim 1, **characterized in that** the magnetic field-producing units (2, 4) are constructed with rotation of symmetry transverse to the distance, the first and second external dimensions being defined transverse to the distance (D₁, D₂) by a first and second diameter, respectively.

3. Magnet arrangement according to Claim 2, **characterized in that** the second external diameter (D₂) is smaller than half the first external diameter (D₁).

4. Magnet arrangement according to Claim 2 or 3, **characterized in that** the ratio of the second external diameter (D₂) to the first external diameter (D₁) is from 1:2 to 1:8.

5. Magnet arrangement according to one of Claims 1 to 4, **characterized in that** a relative distance between the two magnetic field-producing units (2, 4) is in the region of half to the whole first external diameter (D₁).

6. Magnet arrangement according to one of Claims 1 to 5, **characterized in that** the first magnetic field-producing unit (2) is designed as a ring.

7. Magnet arrangement according to one of Claims 1 to 6, **characterized in that** at least one magnetic field-producing unit (2) comprises a permanent magnet.

8. Magnet arrangement according to one of Claims 1 to 7, **characterized in that** the first magnetic field-producing unit (2) comprises an annular permanent magnet which has a magnetization (24) with a radially aligned component.

9. Magnet arrangement according to one of Claims 1 to 8, **characterized in that** at least one magnetic field-producing unit (2, 4) comprises a resistive electromagnet.

10. Magnet arrangement according to one of Claims 1 to 9, **characterized in that** the second magnetic field-producing unit (4) has a cut-out at a side facing the region of the homogeneous magnetic field (8).

11. Magnet arrangement according to one of Claims 1 to 10, **characterized in that** the magnetic field-producing units (2, 4) are surrounded by a ferromagnetic material (16, 18) at sides (14) averted from the region of the homogeneous magnetic field (8).

12. Magnet arrangement according to one of Claims 1 to 11, **characterized in that** the two magnetic field-producing units (2, 4) are connected to one another with the aid of a flux feedback unit (20) made of a ferromagnetic material.

## Revendications

1. Dispositif magnétique pour un appareil de diagnostic à résonance magnétique, constitué d'une première unité (2) de génération de champ magnétique et d'une second unité (4) de génération de champ magnétique, avec un écartement par rapport à la première, chacune d'elles présentant respectivement des première et seconde dimensions (D₁ ou D₂) transversalement à leur écartement, lesquelles unités (2, 4) de génération de champ magnétique définissent une région (8) de champ magnétique homogène qui se trouve essentiellement entre les deux unités (2, 4) de génération de champ magnétique, et d'un accès (12) à la région (8) qui est orienté transversalement à l'écartement des deux unités (2, 4) de génération de champ magnétique, les secondes dimensions extérieures (D₂) étant inférieures aux premières dimensions extérieures (D₁). **caractérisé en ce que** la première unité (2) de génération de champ magnétique présente une ouverture (11) qui est ménagée en tant qu'accès supplémentaire à la région (8).

2. Dispositif magnétique selon la revendication 1, **caractérisé en ce que** les unités (2, 4) de génération de champ magnétique sont conformées en symétrie de révolution transversalement à leur écartement, les première et seconde dimensions extérieures (D₁, D₂) transversalement l'écartement étant définies respectivement par un premier et un second diamètre.

3. Dispositif magnétique selon la revendication 2, **caractérisé en ce que** le second diamètre extérieur (D₂) est inférieur à la moitié du premier diamètre extérieur (D₁).

4. Dispositif magnétique selon la revendication 2 ou 3, **caractérisé en que** le rapport du second diamètre extérieur (D₂) sur le premier diamètre extérieur (D₁) est compris entre 1:2 et 1:8.

5. Dispositif magnétique selon l'une des revendications 1 à 4, **caractérisé en ce qu'**un écartement des deux unités (2, 4) de génération de champ magnétique est compris entre une valeur correspondant à la moitié du premier diamètre extérieur et une valeur correspondant à tout le premier diamètre extérieur (D₁).

6. Dispositif magnétique selon l'une des revendication 1 à 6, **caractérisé en ce que** la première unité (2) de champ magnétique est conformés en couronne.

7. Dispositif magnétique selon l'une des revendications 1 à 7, **caractérisé en ce qu'**au moins une unité de champ magnétique (2) comporte un aimant permanent.

8. Dispositif magnétique selon l'une des revendications 1 à 8, **caractérisé en ce que** la première unité (2) de génération de champ magnétique comporte un aimant permanent en couronne qui possède une magnétisation (24) dont une composante est orientée radialement.

9. Dispositif magnétique selon l'une des revendications 1 à 9, **caractérisé en ce qu'**au moins une unité (2, 4) de génération de champ magnétique comporte un aimant électromagnétique résistif.

10. Dispositif magnétique selon des revendications 1 à 9, **caractérisé en ce que** la seconde unité (4) de génération de champ magnétique présente un creux sur le côté dirigé vers la région (8) de champ magnétique homogène.

11. Dispositif magnétique selon l'une des revendications 1 à 10, **caractérisé en ce que** les unités (2, 4) de génération de champ magnétique sont entourées sur les côtés (14), éloignée de la région (8) de champ magnétique homogène, par un matériau ferromagnétique (16, 18).

12. Dispositif magnétique selon l'une des revendications 1 à 12, **caractérisé en ce que** les deux unités (2, 4) de génération de champ magnétique sont reliées entre elles par un retour de flux (20) en un matériau ferromagnétique.
